Europäisches Patentamt

(19) European Patent Office

Office européen des brevets

(11) Publication number : **0 303 856 B1**

# EUROPEAN PATENT SPECIFICATION

(45) Date of publication of patent specification :
05.04.95 Bulletin 95/14

(51) Int. Cl.$^6$ : **G06F 11/20, G06F 11/14, G06F 13/12**

(21) Application number : 88112033.1

(22) Date of filing : 26.07.88

(54) **Method and apparatus for maintaining duplex-paired devices by means of a dual copy function.**

(30) Priority : 20.08.87 US 87331
25.08.87 US 89151

(43) Date of publication of application :
22.02.89 Bulletin 89/08

(45) Publication of the grant of the patent :
05.04.95 Bulletin 95/14

(84) Designated Contracting States :
DE FR GB IT

(56) References cited :
EP-A- 0 156 179
US-A- 4 207 609
US-A- 4 686 620
THE 6TH INTERNATIONAL CONFERENCE ON
DISTRIBUTED COMPUTING SYSTEMS,
Cambridge,Massachusetts, 19th - 23rd May
1986, pages 621-627, IEEE, New York, US;B.
BHARGAVA et al.: "Site recovery in replicated
distributed database systems"
IBM TECHNICAL DISCLOSURE BULLETIN,
vol. 29, no. 11, April 1987, page 4816, New
York, US; "DASD update processing"

(73) Proprietor : International Business Machines
Corporation
Old Orchard Road
Armonk, N.Y. 10504 (US)

(72) Inventor : Berger, Blaine H.
2941 Bowline Place
Longmont Colorado 80501 (US)
Inventor : Smith, Bret P.
742 Cameron Lane
Longmont Colorado 80501 (US)
Inventor : Beardsley, Brent C.
9533 East Stella Drive
Tucson Arizona 85730 (US)
Inventor : Boulia, Lawrence Herbert
12149 McDonald Chapel Drive
Gaithersburg Md. 20878 (US)
Inventor : Vosacek, Robert Haver
11205 Chuckwagon Circle
Tucson Arizona 85749 (US)

(74) Representative : Burt, Roger James, Dr.
IBM United Kingdom Limited
Intellectual Property Department
Hursley Park
Winchester Hampshire SO21 2JN (GB)

## Description

This invention generally relates to improvements in data storage devices for the input and output of information to a data processing system and, more particularly, to a dual copy function in a disk storage device. Each write to the primary storage device is also written to a secondary storage device. Tables are employed to manage the records to be updated and their locations on the physical medium. A status array is also employed to retain the status and device identification information on a status track of each of the data storage devices and another location to provide global identification and management of interchangeable data storage devices.

The past several years have seen the growth of on-line workstations, the evolution of distributed processing, and the acceleration of information technology in many new application areas. The result has been an increase in the use of on-line data base systems and a growth in the requirement for storage capacity and increased reliability and flexibility in data storage devices.

The concepts of self-test, redundancy, cross-check verification between various sources of information and the like are well known in the art. Particularly, with the advent of complex digital computer systems used for applications such as process control or supervisory control. An example of such a system is illustrated in U.S. Patent 4,032,757 to Eccles, which uses a pair of channels to continually compare the events occurring in each computer. The constant comparison allows the additional processor to quickly take over control of the process if the other processor fails. The problem with this approach is the time that the extra processor needs to begin processing after a failure. In critical processes such as a nuclear power plant, any time lag could be unacceptable. Another approach is presented in U.S. Patent 4,270,168 to Murphy et al., which uses a plurality of processors, self checks and joint answer checking to assure that each processor can assume real time utilisation for another processor in the event of a failure. The increased reliability presented in these systems is a memory resident application approach that fails to handle a large data base application spanning many data storage devices.

The general configuration of a data processing system typically comprises a host processor or processors, a memory and various peripheral units. The peripheral units include terminals, printers, communications devices and data storage devices (DASD). We are concerned with the control that provides information from DASD to a data base application residing in the host processor memory. A good example of prior art approaches to this type of processing is presented in U.S. Patent 3,999,163 to Levy et al., U.S. Patent 4,067,059 to Derchak and U.S. Patent 4,189,769 to Cook et al. These patents present various ways to enable a host to process information residing on DASD. While production systems described readily lend themselves to data base applications, they are lacking the capability of retaining status information when a power-off occurs in an environment designed to provide high availability of DASD information.

In a known data processing system, a memory control circuit connected to each of a plurality of memory banks selectively transfers the contents of arbitrary first of the memory banks to a selected second of the memory banks in a manner whereby, if a first memory bank is written into the utilising circuit transfers the contents into a second memory bank thereby preventing a loss of information. An example of such a system is illustrated in U.S. Patent 3,866,182 to Yamada et al.

The present invention provides a method of managing a first and a second data storage device in a data processing system of the type having a host system, an attached controller comprising a set of storage paths attached to a cache, a data storage device controller, a non-volatile storage, and a memory containing a joint array structure comprising a data translation table and a status table, the data storage device controller comprising attaching means for a plurality of strings of data storage devices, each of the data storage devices including a plurality of records, a plurality of tracks, and a device status track having a reconfiguration count, a device identification number and controller identification number recorded thereon, the status table in the joint array structure comprising means for storing the reconfiguration count, the device identification number and the controller identification number for each of the data storage devices.

The method comprises the steps of assigning a predetermined number of bits for each of the records stored in the first and second data storage devices to identify changes to the records, storing on a stack a cell number comprising said predetermined number of bits for each of the records from the first data storage device said cell number being a predetermined bit field specifying a record on said data storage devices, checking the stack periodically to identify a set of records which have changed, and writing the set of records which have changed to the second data storage device, whereby the first and second data storage devices are managed to maintain identical the copies of data records stored therein.

The invention also relates to a data processing system for managing a first and a second data storage device comprising a host system containing a plurality of channels, a controller attached to at least one of the channels and comprising a set of storage paths, each of the storage paths having access to a cache, a data storage device controller, a non-volatile storage, and a memory comprising a joint array structure having a data translation table and a status table, and a plurality of strings of data storage devices attached to the data storage device controller, each of the data storage devices including a plurality of records, a plurality of tracks, and a device status track having a reconfiguration count, a device identification number and controller identification number recorded thereon, the joint array structure of the controller comprising means for storing the reconfiguration count, the device identification number and the controller identification number for each of the data storage devices, means for assigning a predetermined number of bits for each of the records stored in the first and second data storage devices to identify changes to the records, means for storing on a stack a cell number comprising the predetermined number of bits for each of the records from the first data storage device said cell number being a predetermined bit field specifying a record on said data storage devices, means for periodically checking said stack to identify a set of records which have changed, and means for writing the set of records which have changed to the second data storage device, whereby the first and second data storage devices are managed to maintain identical the copies of data records stored therein.

Thus, there is provided a way of uniquely identifying fields on a data storage device for the purpose of duplicating the information to another medium. A primary and secondary data storage device are also used to implement the dual copy environment. A management facility is used to update the secondary device with only the fields that have changed on the primary device. A method of employing the data storage devices to keep important status information non-volatile for integrity purposes is also employed.

The present invention will be described further with reference to an embodiment thereof as well as an example of the prior art and illustrated in the accompanying drawings, in which:

Figure 1 is a block diagram showing a prior art data storage system of U.S. Patent 4,207,609;

Figure 2 is a highly styalised block diagram showing the basic elements of the new data storage system;

Figure 3 is a block diagram showing the parts of the joint array structure;

Figure 4 is a flow diagram showing the flow of a data storage request from the host to the storage system and back; and

Figure 5 is a flow diagram showing the creation of the cell number stack in controller storage.

The following disclosure describes a method for improved management of data storage devices and the data stored on them. Status and identification information is retained on the data storage devices and a backup medium to assure the retention of information when a power out or other disablement of the devices occur and to verify that the correct physical devices are still attached to the controllers when the data storage device resumes operation.

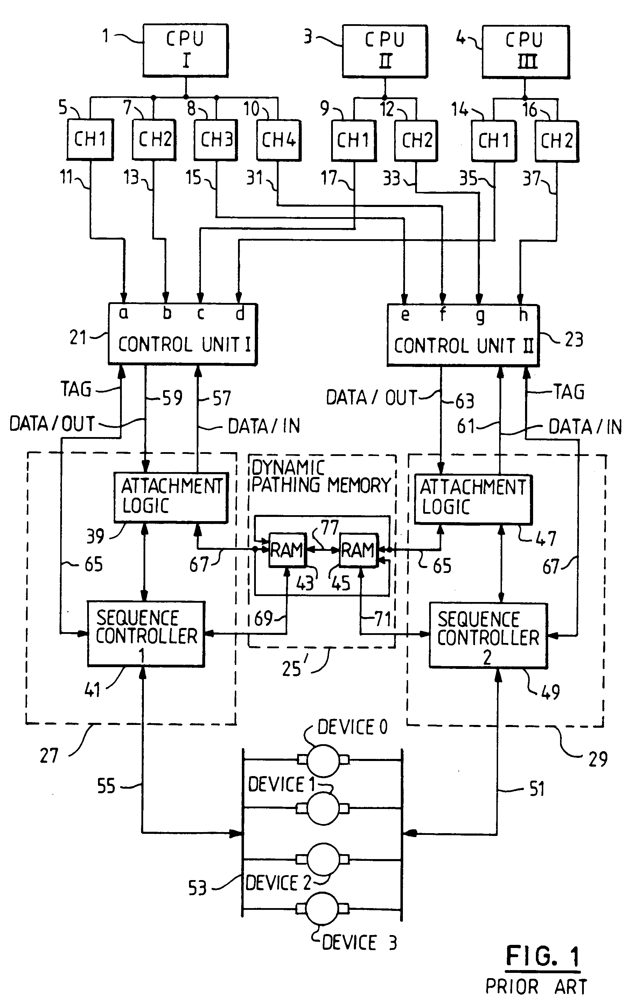

Referring now to the drawings, and more particularly to Figure 1, there is depicted a typical prior art data storage system. Figure 1 shows a multi-CPU and shared DASD configuration according to U.S. Patent 4,207,609 assigned to the assignee of this invention. Three CPU's 1, 3, and 4 hereinafter designated by Roman numerals respectively CPU I, CPU II and CPU III, are suitably cross-connected to a pair of control units 21 and 23, hereinafter designated CU I and CU II over counterpart channels. In this regard, CPU I attaches four channels 5, 7, 8 and 10; CPU II attaches two channels, 9, 12, and CPU III attaches two channels 14 and 16. Channels 1 and 2 of CPU I terminate in CU I ports a and b, while channels 3 and 4 of CPU I terminate in CU II ports e and f. Channel 1 of CPU II terminates in CU I port c with channel 2 of CPU II attaching CU II at port g. Lastly, channel 1 of CPU III drives port d of CU I with channel 2 of CPU III driving port H of CU II. CU I and CU II attach devices 53 through DASD controllers 27 and 29 over a demand/response interface embracing tag and data lines. The interface between CU I and DASD controller 27 includes tag lines 65 and data/in and data/out lines 57 and 59. Likewise, tag lines 67 and data/in and data/out paths 61 and 63 couple CU II to DASD controller 29.

The demand/response type interface is one in which the tag out identifies and validates the information on the data line out and vis-a-vis. In this regard, each CPU/control unit/device operates asynchronously with respect to one another in which directional control is asserted from the top down. Active connection between elements for executing operations is necessary for extended periods only in respect of the movement of data from device to channel or from channel to device. Otherwise, tasks or operations may be performed in disconnect mode.

Devices 53 are accessed either through DASD controller 27 or DASD controller 29. DASD controller 27 includes attachment logic 39 and sequence controller 41 coupling devices 53 over path 55. Similarly, DASD controller 29 includes attachment logic 47 and sequence controller 49 to operate devices 53 over path 51.

Between the DASD controllers 27 and 29, there is juxtaposed dynamic pathing memory 25'. This memory contains the map of network topology and the necessary context information utilised by the CU's in managing the connection between CPU's to devices. Memory 25' comprises a pair of random access memories (RAM) 43 and 45 which can be commonly accessed by either CU through the appropriate attachment logic. CU I can access for reading, writing or updating purposes RAM 43 and 45 through attachment logic 39, path 67. CU II can commonly access the RAM's over attachment logic 47 and path 65. The operations concerned with accessing of devices 53 involving the dispatching and positioning of electro-mechanical elements such as the head disk arm assembly on direct access storage devices 0-4 is regulated by the commands and parameters sent from the control unit through the attachment logic and sequence controller. An example of the host CPU's is the IBM 3090 processor. The IBM 3090 is a compatible growth system which uses either Multiple Virtual Storage/Extended Architecture (MVS/XA) or Virtual Machine (VM) as an operating system. The operating system controls the flow of data to/from main storage and provides an application environment which is System/370 compatible. The IBM 3090 processor is described in more detail in IBM publication, 3090 Processor Complex Installation Manual - Physical Planning, GC22-7074. An example of a DASD controller 27 and 29 is the IBM 3880 model 23 DASD controller. The IBM 3880 model 23 contains a high speed cache and two storage directors 41 and 49, each with a single storage path for independent control of attached DASD devices 53. The IBM 3880 model 23 controller is described in IBM publication, IBM 3880 Storage Control Model 23 Description, GA32-0082. A good example of a DASD devices 0-3 are the IBM 3380, which provides a fixed-medium head and disk assembly (HDA) that contains the heads, disks and access mechanisms (actuators) within a sealed enclosure. Each 3380 unit contains two HDAs. There are two independent, movable actuators within each HDA. Each actuator has its own address which is selectable from the CPU's. A string of DASDs attached to a 3880 storage director can contain four units (sixteen actuators). A more detailed description of the IBM 3380 DASD is found in IBM publication, 3380 Description and User's Guide, GA26-1664.

To understand the subject invention, it will be necessary to discuss some of the details of the prior art DASD system operation. When the host CPU requires information, it requests it by requesting a specific channel, controller and DASD actuator. The channel number is a one byte hexadecimal number, the controller is a four bit hexadecimal number and the DASD actuator number is a four bit hexadecimal number. For example, if the host sent a two byte hexadecimal address 0111 in a start input/output operation (I/O), then actuator one, attached to controller one, attached to channel one would prepare for I/O and send the host CPU a ready signal. Since the mapping down and back is the same, the original transaction header can be used to determine the path back to the host. Any host program accessing the DASD could send the header described above to uniquely define the DASD actuator to access.

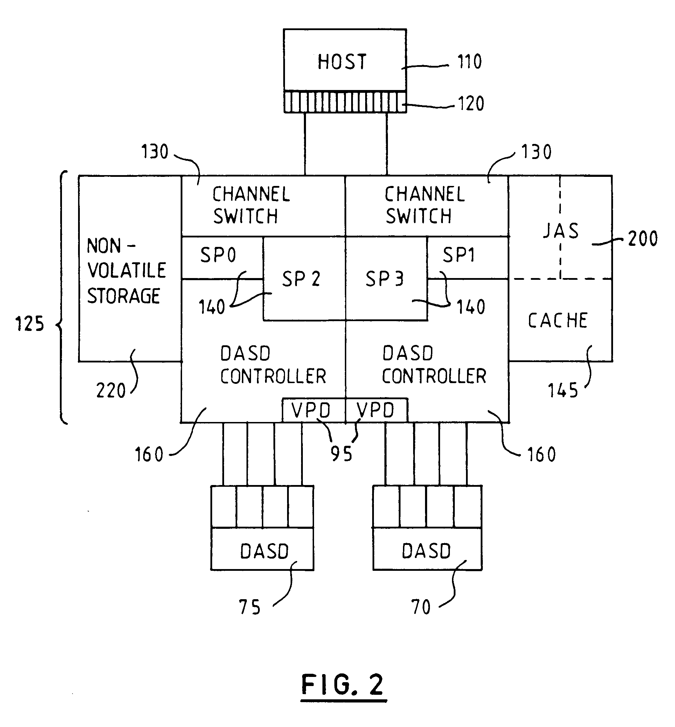

Referring now to Figure 2, a diagram showing the basic elements of the new data storage system is shown. The basic structure is very similar to Figure 1. A host CPU 110 is attached via its channels 120 to a DASD controller 160 which is attached to two DASD strings 70 and 75. Information is passed through the described path to the host. A difference to be noted between the prior art and the disclosed arrangement is the subsystem status which contains information used to manage the data storage system and the non-volatile storage 220. The DASD controller 160 also contains an EPROM vital product data area at 95. The vital product data area contains pointers to the global status track.

The joint array structure (JAS) 200 is used to conserve the host to DASD interface and implement the dual copy, high availability functions. The dual copy function provides enhanced data availability and reliability by maintaining two identical copies of volumes, called a duplex pair, on two physically separated DASD units, for example, the primary data storage device 70 and the secondary data storage device 75. The dual copy has a first copy of the data which is referred to as a primary copy and a second copy which is referred to as a secondary copy.

Once the duplex pair is established, the DASD controller 160 provides an image of the duplex pair using control information kept in the JAS 200 as a single highly available volume. Both volumes of the duplex pair are updated as a result of a single write request. A single read request to a dual copy data storage device is handled in accordance with normal cache algorithms unless the data is not in the cache in which case the controller attempts to read the data from the primary device. Reads which fail on the primary device are attempted on the secondary device of the duplex pair.

The other feature that is unique to this invention is the non-volatile storage 220. The dual copy function requires the non-volatile storage 220 for operation. The non-volatile storage is used to hold transferred data so that the subsystem can signal completion of a write operation before the actual write to DASD transpires. This feature also provides information necessary for re-synchronising two volumes of a dual copy pair when a failure is repaired.

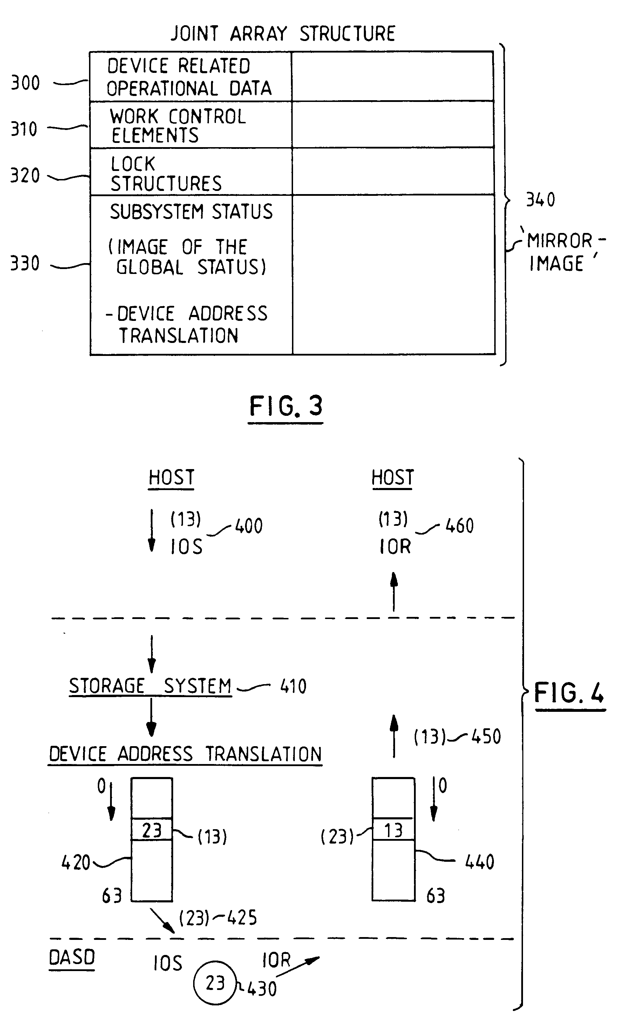

The JAS 200 conserves the host interface by translating the standard host header described above in the prior art illustrated in Figure 1 into the actual physical DASD actuator through the use of a pair of translate tables. The first table is used to translate the actuator address and the second table is used to translate the return host address. The structure of the joint array is shown in Figure 3. The joint array structure comprises a sixty-four byte area to support device address translation. The JAS 200 also contains device related operational data 300, work control elements 310, lock structures 320 and subsystem status information 330.

A mirror-image of the control and status information listed above is contained in the other half 340 of the JAS 200 for redundancy. The subsystem status information 330 includes the global status and the device address translation. The device address translation provides the address lookup capability necessary to conserve the system interface and still take advantage of the dual copy feature, non-volatile storage and global subsystem status. An example will help to clarify the usage of the address translation table. In Figure 4, a host application has requested an I/O start of actuator thirteen 400. This request goes out over the channel to the storage system controller 410 where the thirteenth byte of the sixty-three byte address table 420 is accessed to obtain the actual address of the actual actuator that host address thirteen is mapped to. Twenty-three is the actual actuator address as shown at 425, so actuator twenty-three is prepared for I/O and returns an I/O ready signal at 430. However, to determine where to send the signal, it is necessary to look up the return address in the return address table of the data address translation at 440. The return address is thirteen as indicated at 450, and this value is used to return the I/O ready to the host at 460. The use and initialisation of the device address translation tables is presented in more detail below.

To understand the method better, a preferred embodiment is described employing the environment presented in Figure 2. A first data storage device in string 70 and a second data storage device in string 75 each have a dedicated status track for the retention of status information. The dedicated status track is unusable by non-system applications and retains two copies of the global subsystem status for the controller and the first and second data storage devices. The storage subsystem is the set consisting of the controller and the attached data storage devices. In the example, this consists of the single controller 125 and the two data storage devices 70 and 75.

Status information about the subsystem is retained across power downs by writing a single record of status and identification information twice on the status track of each device. Global subsystem status is also kept on the first and second data storage devices 70 and 75. Device identification is kept on all the devices in the subsystem, but global subsystem status is only kept on the two global data storage devices. The global subsystem status portion of the record is formatted but not used if the device is not one of the two global subsystem status devices.

The global status pointer contains address information about the two data storage devices and a count of how many times the devices have been reassigned, which is used at initial program load to determine which is the most current copy of the global status pair. A more detailed description of the global status pointer is provided below.

The global subsystem status consists of the following information:

The global status pointer which is a four byte field including the one-byte address of each of the data storage devices including the first and second global data storage devices and a two-byte number which indicates the number of times the definition of the data storage devices have changed. Global status contains the status of the subsystem components, a cache store 145 and a non-volatile storage 220, and devices 70 and 75 as established by failure or system commands.

Information on the status track is divided into device identification and status information. Device identification information is used to insure that the DASD device attached is the one that the subsystem expects. The status information is divided into two types: subsystem status and device status. Subsystem status contains information that pertains to the entire subsystem rather than to a specific device such as the global status pointer, whether the subsystem storage is available or not and information to help insure the integrity of the non-volatile store. The device status contains information that pertains to a specific DASD device such as the channel address that the device will respond to, whether the device is active for cache or fast write or not, and the duplex pair status of the device. Other information is included with the status track. The above are examples of the information identified.

The global subsystem status information discussed above is kept on two devices for availability reasons. However, each device has its device number written. If one device should fail, then the other will be used to keep the information and the failed device will be replaced by another operational device.

Each controller has vital product data that is maintained and used to identify and establish information concerning the hardware characteristics of the attached devices. The vital product data is stored in EPROM in each controller as depicted at 95 and 96 of Figure 2.

The information includes:
Model type
Configuration
System Adapter and System Address
Subsystem Storage Identification
Storage Control Serial Numbers
Subsystem Storage Size
Non-volatile Storage Size

Global Status Pointer
Controller Type For Each String
Maximum Number of Drives Configured For Each String

This information is used to initialise the JAS 200 in the controller 125 to reflect the current system's configuration. In our example, the JAS 200 contains the addresses that data storage device 70 and data storage device 75 are known to the host 110.

When the subsystem is initialised, the following steps are performed:

The devices undergo an initial microprogram load (IML) to establish an operational data path between the attaching channels and the attached devices. The Storage Path (SP) microcode is loaded from the IML device by the support facility in the data storage device. A SP 140 is an addressable, independent processor that routes data to a data storage device 70 or 75. A basic assurance test routine is run to insure that the storage path is operational. This process is coordinated for all of the SPs 140 in the subsystem residing on the controller 125. Each SP 140 can complete IML independent of the other SPs. The location of a global status device is required before access is permitted. If an IML device pointer is available, the most recent pointer must agree with the available device or devices. If one IML device pointer is available, it must point to one device with identical pointers. The IML device pointer does not have to be identical to the device pointer.

Then, the global subsystem status array is read from each of the two global subsystem data storage devices 75 and 70. When valid and current global subsystem status is identified, the global subsystem status is written to both data storage devices to insure the information is consistent on both of the devices. As devices become available, the device number and subsystem identification number of each data storage device is read and checked against the global status array to ensure that the correct hardware is attached and no movement has occurred. When this process is completed, the host is notified of the available SPs 140 and normal processing commences. Device identification is verified to assure that data left in the non-volatile store for a device is not applied to the wrong device because of a device reconfiguration as a result of device replacement, for instance.

If the current device availability allows a better global subsystem status device configuration, the devices will be reconfigured following these rules:

1) put the devices on separate strings;
2) put the devices on separate units; and
3) put the devices on separate spindles.

The global subsystem status devices are also reassigned by the controller when the controller can only access one of a pair of devices. If it is necessary for any of the reasons described above to reconfigure the system, the order of update will be as follows:

1) Increment the reconfiguration count in the global status pointer to show a reconfiguration has taken place.
2) Global subsystem status will be written to the new global status device. Its status will reflect the new pair.
3) The global subsystem status will be written to the old but still working global status device (in the case of the malfunctioning unit).
4) The global status pointer will be updated in both EPROM vital product areas 95 and 96.

The reconfigured system will be optimally tuned and ready for use when the operations described above are completed.

In operation, if either the primary or the secondary data storage device begins to show signs of failure, the controller will replace the failing device and copy the global status to another data storage device. Then, that data storage device's address will be substituted into the device address translation of the JAS 200 as the secondary storage device for the dual copy and the system will continue to process with minimal impact to the host.

Four data storage device states are defined with respect to the dual copy function:

Simplex or "single copy" volume. The data storage device is treated as though it were attached to a subsystem which does not provide the dual copy function. No secondary data storage device is maintained. All read/write activity accesses the addressed data storage device only.

Duplex or "two copy" volume. The two volumes, primary and secondary, are identified as a duplex pair. Only the primary data storage device is directly accessible by the host systems. The secondary data storage device rejects all direct host calls except error diagnostics.

Duplex Pending is a temporary state. The two volumes, primary and secondary, are identified as a duplex pair and the subsystem carries out a copy to synchronise the two devices. Only the primary data storage device is directly accessible by the host systems. The secondary data storage device rejects all direct host calls except error diagnostics.

Failed Duplex is an error state. The two volumes, primary and secondary, are identified as a duplex pair. Either an attaching host system has requested that the subsystem should not continue duplicate writes for this duplex pair or the controller has determined that it was unable to synchronise the contents of the two volumes and has suppressed duplicate writes. In this state, a bit map is maintained in non-volatile storage to track the cylinders written in this mode. The subsystem will begin recovery operations as described above when this state is detected.

Once the duplex pair is in the full duplex mode, the controller ensures that the two volumes are identical by updating both volumes as the result of any write issued to the primary data storage device of the pair. This duplicate write is transparent to the attaching host systems. The duplicate update is accomplished by orienting the primary data storage device and performing a branching write, updating the primary data storage device and capturing only the data necessary to duplicate the write to the secondary data storage device.

To update only the changed fields on the primary data storage device, a method for uniquely defining fields on a data storage device is employed. The method identifies any changed fields on the data storage device. As the data storage device spins, the read/write head of the disk drive encounters fields and small gaps between the fields. All processing must be accomplished during these gaps between the fields; otherwise, unnecessary revolutions of the device (overruns) occur which degrade the performance.

Each record stored on the data storage device has an unique identifier. It is called the cell number. Record identifications can be duplicated on the track, so they will not identify a particular record. The cell number is the exact location of the count field on the drive's track. Each record contains three fields: Count, Key and Data. The cell number is stored in the count field in a cell number field which is two bytes long.

As the device spins, the count fields are encountered for every record on the track. Every cell number from each count field is pushed onto a stack in the controller. The three high order bits in the cell number are modified or set depending on which type of write operation is requested by the channel or the host. An example of one element of the cell number stack is provided below.

| C | K | D | Cell Number (13b) | Reserved (4B) |
|---|---|---|---|---|

The C bit of an element on the cell number stack is the count bit, the K bit is the key bit, the D bit is the data bit. The cell number is a thirteen bit field which specifies the unique record on the data storage device. The reserved 4 byte area is for future enhancements. When either the C, K or D bit is on, the record is copied to the secondary data storage device.

Format writes always modify the count fields and set the count C bit. Key and data fields are occasionally modified resulting in their bits being set. For example, update writes never modify count fields but will change key and/or data fields. This information is set in the cell number on the data storage device and copied to the stack in the controller. This stack provides all the information to copy all the modified fields on the primary device to the secondary device.

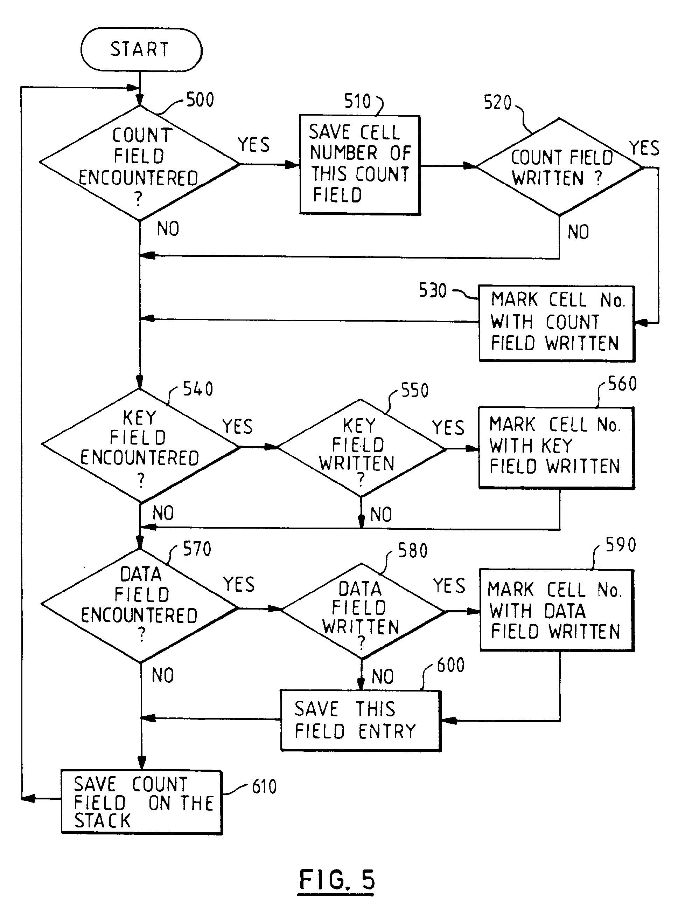

The method for creating the cell number stack in the controller is shown in the flow diagram of Figure 5. While the stack is created in controller memory in this embodiment, those skilled in the art will recognise that it could be maintained in any memory area. Referring now to Figure 5, control enters at decision block 500 where a test is performed to determine if a count field has been encountered on the data storage device. Then, at function block 510, the cell number of the count field is temporarily stored. A test is performed at decision block 520 to determine if the count field was written to the data storage device. If it was written, then the cell number's count bit is set on at function block 530.

Next, control flows to decision block 540 where a test is performed to determine if a key field has been encountered. If a key field has been encountered, then a second test is performed at 550 to determine if the key field was written to a data storage device. If it was written, then the cell number's key bit is set on at function block 560.

Next, control flows to decision block 570 where a test is performed to determine if the data field has been encountered. If a data field has been encountered, then a second test is performed at decision block 580 to determine if the data field was written to a data storage device. If it was written, then the cell number's data bit is set on at function block 590. Whether the data field was written or not, the field's entry is saved at function block 600. The cell number information is stored on the stack at function block 610.

The controller manages the identification and copying of the changed information to the secondary data storage device. The modified records are copied from the cache to the secondary device. While the transfer of information is from cache to secondary storage, one of ordinary skill in the art will recognise that any medium can be used for storage of the information that has been changed, including the primary data storage device. After the transfer of information to the secondary data storage device, the controller sets a status in the available for further processing.

The duplex pending state of the dual copy looks the same to the attached host. Input/Output (I/O) requests to the data storage device will be handled the same as in Duplex with the following exceptions:

1) The device being copied from will be the one that I/O is performed on (the logical primary), whether it is the primary or the secondary device.

2) If the I/O is a write and it is to a track that has already been copied, it will be treated the same as in Duplex, except that the device being written to first is the device being copied from.

3) If the I/O is a write and it is to a track that has not been copied, then only the copied from device will be updated. The copy will update the copied to device when it reaches that track.

4) Recovery of the failed reads from the logical secondary will only be attempted if that track has already been copied.

5) Fast write will not be performed until after the copy is complete.

When a duplex pair is established, the primary device in the pair is forced into fast write deactivated state. If fast write is desired, it can be specified after the duplex pair is established. If the primary device has fast write activity, then the pair will be in fast write mode. On cache misses, the normal dual copy algorithm will be used. On cache hits the following procedure is performed:

1) The data from the host will be written to the subsystem storage and the non-volatile storage.

2) Device end will be immediately presented to the host, however the device will remain busy until the data is de-staged to the primary device.

3) The data in the non-volatile storage will represent the data on the secondary device.

4) If the secondary fails, all fast write entries in the non-volatile cache are freed and all cylinders that have entries on the non-volatile cache are marked as out of synchronisation. Fast write will be inactive for further activity on the volume.

5) If the primary fails, then the entries in the non-volatile cache are immediately de-staged to the secondary. Fast write will be inactive for further activity on the volume.

The controller assures high availability by maintaining two copies of every piece of information stored. If either the primary or the secondary data storage device fails, the controller can efficiently replace the faulty device, copy the information from the working data storage device, and bring the dual copy back into synchronisation without any loss of information.

The performance benefits of write operations with cache are limited to operations where the data exists in the cache. Generally, all data in write operations goes directly to the data storage device as well as cache in order to keep the data current on a non-volatile media. Fast write extends the performance benefits of caching to write commands without impacting the reliability or availability of the accessed data. Without fast write, writes require a data storage device access to ensure that the data stored as a result of the write request will not be lost as a result of a loss of power to the controller.

In order for fast write to function, the following environment must exist:

1) Non-volatile storage must be available in the controller.

2) Subsystem storage must be available.

3) Caching must be active.

4) Fast write must be active for the device.

5) The data storage device must have a standard format. Specifically, it must have standard record lengths (record zeros), and it must have unique record identifications.

Fast write applies to all write hits and predictable writes. A write hit involves encountering a set of records that are already in cache in their updated form. A predictable write is a write which only requires the preformatted portion of the track (header and record zero) and does not require user data. Fast write is not applied to cache misses because commands are not guaranteed to be predictive (imbedded error situations can occur). Embedded error situations must be detected and reported prior to the completion of the activity of the commands since they will typically affect the function that should be performed. As an example, prior to indexed volume tables of contents (VTOC) support, insertion of a new data set on a volume involved execution of a command which would search the entire VTOC looking for a data set which had a name the same as the data set to be added. If such a duplicate data set name is found, the new data set is not added; otherwise, the new data set is added by a subsequent command. The command which searches for the duplicate data name relies on a No Record Found to indicate that no duplicate exists. For this case, No Record Found must clearly be reported synchronous to the execution of the commands.

Additionally, for some commands, the count field for a record must be examined in order to determine the key and data lengths of accessed records. The data contents of an accessed track must be examined in order to determine what activity should be performed by the command accessing the track.

Fast write extends to writes the performance benefits that caching has provided for reads. This results in significant improvements in both throughput capability and response time. The data integrity, data availability and data serviceability are maintained for the fast write system. No host software changes are necessary to implement the fast write function.

Fast write uses a non-volatile storage array to assure the integrity of data without performing an actual write to a data storage device. Each data modification is stored in two locations in the controller until the actual data storage device update takes place. One copy is maintained in the controller storage, the other in the non-volatile storage. Two copies of the data are essential in order to maintain data availability comparable to that of standard data storage devices. There are failures within the controller which can make the non-volatile storage or the subsystem storage unavailable to the subsystem. If the subsystem only maintained one copy of data modifications, any failure which made the array containing that data unavailable would compromise the data's integrity.

The fast write is accomplished by performing a branching write, updating the non-volatile storage and the images in the cache simultaneously as a result of a single transfer of data from the channel to the controller. Fast write is allowed only if an image of the track is in cache or if the operation is a predictable write. If an image of the track is in cache, the cache space is previously allocated but may have to have additional segments allocated for format write operations.

A clean final status (channel end and device end) is sent as soon as the data transfer to the cache and non-volatile storage is successfully completed. This status is a commitment by the controller that the data is successfully stored in the controller and will be available for any later reference.

Data movement from the cache/non-volatile storage to the data storage device occurs as a result of an internal controller that performs anticipatory de-staging. Anticipatory de-staging is designed to avoid an instance of a write request being delayed because there is not space available for allocation in either the non-volatile storage or the cache. Anticipatory de-staging maintains a buffer of unmodified space in both the non-volatile storage and the cache. Space in these buffers is immediately available for allocation to satisfy requests to the controller. The amount of available space maintained in each of the buffers is such that concentrated bursts of activity which require space allocation would rarely result in a write being delayed by space allocation. Should such delays be necessary, de-staging will take priority over other internal subsystem activity until the need for the delay is eliminated.

Unlike the general replacement algorithm for the cache where the least recently used (LRU) information is replaced, the de-stage candidate selection algorithm is a first written, first replaced algorithm. This algorithm is based upon two elements of non-volatile space management. First, the non-volatile storage is managed as a circular buffer. When space is needed for allocation, it is allocated immediately in front of a free space pointer. Another pointer indicated the oldest valid data in the buffer (the valid data located the closest in front of the free space pointer). As long as the indicated data transfer can reside in the space between these two pointers, allocation occurs and the transfer begins. Anticipatory de-staging attempts to maintain the amount of free space at some predefined value. Second, the non-volatile storage treats currently allocated space as home areas for any new modifications to the data (records) in that space. If a modification is to be made to a record, allocation determines if an entry for that record exists in the non-volatile storage. If it does and the record is not being reformatted, the update occurs to the pre-allocated non-volatile storage space. If no allocation exists or if the record is being reformatted, then new space is allocated, the update occurs to this space and the old space occupied by the record is indicated as not containing valid data.

Once a de-stage candidate has been selected, the controller is examined to determine if any other modifications for the same track are present. If there are other modifications, the complete set of updates to the track are made as a result of the de-stage for the selected candidate.

Fast write is transparent to the host application. The controller manages the non-volatile storage and data movements between the cache and the data storage device without any host involvement. The controller also handles the error recovery and status logging facilities.

While the invention has been described in terms of a preferred embodiment in a specific operating system environment, those skilled in the art will recognise that the invention can be practiced, with modification, in other and different operating systems within the scope of the appended claims.

## Claims

1. A method of managing a first and a second data storage device (70, 75) in a data processing system of the type having a host system (110), an attached controller (125) comprising a set of storage paths (140) attached to a cache (145), a data storage device controller (160), a non-volatile storage (220), and a memory containing a joint array structure (200) comprising a data translation table and a status table, the data storage device controller (160) comprising attaching means for a plurality of strings of data storage devices (70, 75), each of the data storage devices including a plurality of records, a plurality of tracks, and a device status track having a reconfiguration count, a device identification number and controller identification number recorded thereon, the status table in the joint array structure (200) comprising means for storing said reconfiguration count, said device identification number and said controller identification number for each of the data storage devices,

said method comprising the steps of:

assigning a predetermined number of bits for each of the records stored in the first and second data storage devices (70, 75) to identify changes to the records;

storing on a stack a cell number comprising said predetermined number of bits for each of the records from the first data storage device, said cell number being a predetermined bit field specifying a record on said data storage devices,

checking said stack periodically to identify a set of records which have changed, and

writing the set of records which have changed to the second data storage device,

whereby said first and second data storage devices (70, 75) are managed to maintain identical the copies of data records stored therein.

2. A method as claimed in claim 1, wherein the response to any data storage device failures comprises replacing a failing data storage device with a functioning one of the data storage devices and updating the data translation table in the joint array structure with information identifying the functioning data storage device as the replacement for the failed data storage device.

3. A method as claimed in any preceding claim, wherein an initial memory loading of a data storage device is prevented from being successfully completed unless the controller identification number and the device identification number in the status table of the joint array structure of the controller match respectively the device and controller identification numbers on the device status track of the data storage device.

4. A method as claimed in any preceding claim, wherein the data storage devices distribute information flow over each of the strings by:

connecting each of the data storage devices to the string with the least attached data storage devices; and

connecting the plurality of strings to more than one of the data storage device controller attaching means.

5. A method as claimed in claim 2, wherein the response to any data storage device failures comprises:

incrementing the reconfiguration count in the status table of the joint array structure to indicate that a reconfiguration has taken place; and

writing the incremented reconfiguration count onto the device status track of the functioning data storage device.

6. A data processing system for managing a first and a second data storage device (70, 75) comprising:

a host system (110) containing a plurality of channels (120);

a controller (125) attached to at least one of the channels and comprising a set of storage paths (140), each of the storage paths having access to a cache (145), a data storage device controller (160), a non-volatile storage (220), and a memory comprising a joint array structure (200) having a data translation table and a status table,

a plurality of strings of data storage devices (70, 75) attached to the data storage device controller (160), each of the data storage devices including a plurality of records, a plurality of tracks, and a device status track having a reconfiguration count, a device identification number and controller identification number recorded thereon, the joint array structure of the controller (200) comprising means for storing said reconfiguration count, said device identification number and said controller identification number for each of said data storage devices,

means for assigning a predetermined number of bits for each of the records stored in the first and second data storage devices to identify changes to the records,

means for storing on a stack a cell number comprising the predetermined number of bits for each of the records from the first data storage device, said cell number being a predetermined bit field specifying a record on said data storage devices,

means for periodically checking said stack to identify a set of records which have changed, and

means for writing the set of records which have changed to the second data storage device,

whereby said first and second data storage devices (70, 75) are managed to maintain identical the copies of data records stored therein.

7. A system as claimed in claim 6 further including apparatus for ensuring the integrity of said data storage devices (70, 75) after failures, said apparatus comprising means for comparing the device identification number and the controller identification number in the status table in the joint array structure with the device identification number and the controller identification number on the device status track of the data storage device and means for disabling the operation if the device identification numbers and the controller identification numbers do not respectively match.

## Patentansprüche

1. Eine Methode zum Verwalten eines ersten und eines zweiten Datenspeichergeräts (70, 75) in einem Datenverarbeitungssystem, das über ein Host-System (110) verfügt, einen angeschlossenen Controller (125), einen Satz von Speicherpfaden (140) umfassend, die an einen Cache-Speicher (145) angeschlossen sind, einen Controller für das Datenspeichergerät (160), einen nichtflüchtigen Speicher (220), und einen Speicher, der eine gemeinsame Anordnungs-Struktur (200) enthält, eine Datenübersetzungstabelle und eine Statustabelle umfassend, wobei der Controller des Datenspeichergeräts (160) Anschlußmittel für eine Vielzahl von Strings von Datenspeichergeräten (70, 75) umfaßt, jedes der Datenspeichergeräte eine Vielzahl von Datensätzen enthält, eine Vielzahl von Spuren und eine Gerätestatusspur mit einer darauf aufgezeichneten Rekonfigurationszahl, einer Geräte-Kennnummer und einer Controller-Kennnummer, wobei die Statustabelle in der gemeinsamen Anordnungs-Struktur (200) Mittel zum Speichern der genannten Rekonfigurationszahl, der genannten Geräte-Kennnummer und der Controller-Kennnummer für jedes der Datenspeichergeräte umfaßt,

wobei die genannte Methode folgende Schritte umfaßt:

Zuweisen einer vorbestimmten Anzahl von Bits für jeden in dem ersten und zweiten Datenspeichergerät (70, 75) gespeicherten Datensatz zur Erkennung von Änderungen an den Datensätzen;

Speichern einer Zellennummer auf einem Stapel, wobei diese Zellennummer die genannte vorbestimmte Anzahl von Bits für jeden Datensatz von dem ersten und dem zweiten Datenspeichergerät umfaßt, wobei die genannte Zellennummer ein vorbestimmtes Bit-Feld ist, welches einen Datensatz auf den genannten Datenspeichergeräten bezeichnet,

periodisches Prüfen des genannten Stapels zur Erkennung einer Gruppe von Datensätzen, die sich geändert haben, und

Schreiben der Gruppe von geänderten Datensätzen auf das zweite Datenspeichergerät,

wobei das genannte erste und zweite Datenspeichergerät (70, 75) so verwaltet werden, daß sie die Kopien der darin gespeicherten Datensätze identisch halten.

2. Eine Methode nach Anspruch 1, bei der die Reaktion auf den Ausfall eines Datenspeichergeräts das Auswechseln eines ausgefallenen Datenspeichergeräts gegen ein funktionsfähiges Datenspeichergerät beinhaltet und das Aktualisieren der Datenübersetzungstabelle in der gemeinsamen Anordnungs-Struktur mit Informationen, welche das funktionsfähige Datenspeichergerät als das Ersatzgerät für das ausgefallene Datenspeichergerät kennzeichnen.

3. Eine Methode nach jedem der vorangehenden Ansprüche, bei der ein erfolgreiches Urladen des Speichers eines Datenspeichergeräts solange verhindert wird, bis die Controller-Kennnummer und Geräte-Kennnummer in der Statustabelle der gemeinsamen Anordnungs-Struktur des Controllers mit der Geräte- beziehungsweise Controller-Kennnummer auf der Geräte-Statusspur des Datenspeichergeräts übereinstimmen.

4. Eine Methode nach jedem der vorangehenden Ansprüche, bei der die Datenspeichergeräte den Informationsfluß über jeden String folgendermaßen verteilen:

Verbinden jedes Datenspeichergeräts mit dem String, an den die wenigsten Datenspeichergeräte angeschlossen sind; und

Verbinden der Vielzahl von Strings mit mehr als einem Anschlußmittel des Controllers des Datenspeichergeräts.

5.  Eine Methode nach Anspruch 2, bei der die Reaktion auf den Ausfall eines Datenspeichergeräts folgendes umfaßt:

Inkrementieren der Rekonfigurationszahl in der Statustabelle der gemeinsamen Anordnungs-Struktur, um anzuzeigen, daß eine Rekonfiguration stattgefunden hat; und

Schreiben der inkrementierten Rekonfigurationszahl auf die Geräte-Statusspur des funktionierenden Datenspeichergeräts.

6.  Ein Datenverarbeitungssystem zur Verwaltung eines ersten und eines zweiten Datenspeichergeräts (70, 75), folgendes umfassend:

ein Host-System (110), das eine Vielzahl von Kanälen (120) enthält;

einen Controller (125), der an mindestens einen der Kanäle angeschlossen ist und einen Satz von Speicherpfaden (140) umfaßt, wobei jeder Speicherpfad Zugriff auf einen Cache-Speicher (145), einen Controller für das Datenspeichergerät (160), einen nichtflüchtigen Speicher (220) und einen Speicher hat, der eine gemeinsame Anordnungs-Struktur (200) enthält und über eine Datenübersetzungstabelle und eine Statustabelle verfügt,

eine Vielzahl von Strings von Datenspeichergeräten (70, 75), die an den Controller für die Datenspeichergeräte (160) angeschlossen sind, wobei jedes Datenspeichergerät eine Vielzahl von Datensätzen, eine Vielzahl von Spuren und eine Geräte-Statusspur enthält, mit einer darauf aufgezeichneten Rekonfigurationszahl, einer Geräte-Kennnummer und einer Controller-Kennnummer, wobei die gemeinsame Anordnungs-Struktur des Controllers (200) Mittel zum Speichern der genannten Rekonfigurationszahl, der genannten Geräte-Kennnummer und der genannten Controller-Kennnummer für jedes der genannten Datenspeichergeräte umfaßt,

Mittel zum Zuweisen einer vorbestimmten Anzahl von Bits für jeden in dem ersten und zweiten Datenspeichergerät gespeicherten Datensatz zur Erkennung von Änderungen an den Datensätzen,

Mittel zum Speichern einer Zellennummer auf einem Stapel, wobei die Zellennummer die vorbestimmte Anzahl von Bits für jeden Datensatz von dem ersten Datenspeichergerät umfaßt, wobei die genannte Zellennummer ein vorbestimmtes Bit-Feld ist, das einen Datensatz auf den genannten Datenspeichergeräten bezeichnet,

Mittel für die periodische Prüfung des genannten Stapels zur Erkennung von Datensatz-Gruppen, die sich verändert haben, und

Mittel zum Schreiben der geänderten Datensatz-Gruppe auf das zweite Datenspeichergerät,

wodurch das genannte erste und zweite Datenspeichergerät (70, 75) so verwaltet werden, daß die Kopien der darin gespeicherten Datensätze identisch gehalten werden.

7.  Ein System nach Anspruch 6, desweiteren ein Gerät enthaltend zur Gewährleistung der Integrität der genannten Datenspeichergeräte (70, 75) nach Ausfällen, wobei das genannte Gerät Mittel umfaßt für den Vergleich der Geräte-Kennnummer und der Controller-Kennnummer in der Statustabelle in der gemeinsamen Anordnungs-Struktur mit der Geräte-Kennnummer und der Controller-Kennnummer auf der Geräte-Statusspur des Datenspeichergeräts und Mittel zum Sperren des Betriebs, wenn die Geräte-Kennnummern beziehungsweise die Controller-Kennnummern nicht übereinstimmen.

**Revendications**

1.  Procédé de gestion d'un premier et d'un deuxième dispositifs d'emmagasinage (70, 75) dans un système de traitement de données du type ayant un système hôte (110), un contrôleur rattaché (125) comprenant un ensemble de trajets de mémoire (140) connectés à une antémémoire (145), un contrôleur de dispositif d'emmagasinage de données (160), une mémoire non volatile (220), et une mémoire contenant une structure en tableau collectif (200) comprenant une table de translation de données et une table d'états, le contrôleur de dispositif d'emmagasinage de données (160) comprenant un moyen de rattachement pour une pluralité de chaînes de dispositifs d'emmagasinage de données (70, 75), chacun des dispositifs d'emmagasinage de données comprenant une pluralité d'enregistrements, une pluralité de pistes, et une piste

EP 0 303 856 B1

d'état de dispositif sur laquelle sont enregistrés un compte de reconfigurations, un numéro d'identification de dispositif et un numéro d'identification de contrôleur, la table d'états dans la structure en tableau collectif(200) comprenant des moyens pour emmagasiner ledit compte de reconfigurations, ledit numéro d'identification de dispositif et ledit numéro d'identification de contrôleur de chacun des dispositifs d'emmagasinage de données,

ledit procédé comprenant les étapes de:

attribuer un nombre prédéterminé de bits à chacun des enregistrements emmagasinés dans les premier et deuxième dispositifs d'emmagasinage (70, 75) pour identifier des changements sur les enregistrements;

emmagasiner sur une pile un numéro de cellule comprenant ledit nombre prédéterminé de bits pour chacun des enregistrements du premier dispositif d'emmagasinage de données, ledit numéro de cellule étant un champ binaire prédéterminé spécifiant un enregistrement sur lesdits dispositifs d'emmagasinage de données,

vérifier périodiquement ladite pile pour identifier un ensemble d'enregistrements qui ont changé, et

écrire l'ensemble d'enregistrements qui ont changé sur la deuxième dispositif d'emmagasinage, ce qui fait lesdits premier et deuxième dispositifs d'emmagasinage (70, 75) sont gérés pour maintenir identiques les copies des enregistrements de données emmagasinés dedans.

2. Procédé selon la revendication 1, dans lequel la réponse à des pannes d'un dispositif d'emmagasinage de données quelconque comprend le remplacement d'un dispositif d'emmagasinage de données en panne par un des dispositifs d'emmagasinage de données qui fonctionne et la mise à jour de la table de translation de données dans la structure en tableau collectif par des informations identifiant le dispositif d'emmagasinage de données qui fonctionne comme étant le remplaçant du dispositif d'emmagasinage de données en panne.

3. Procédé selon l'une ou l'autre des revendications précédentes, dans lequel un chargement de mémoire initial d'un dispositif d'emmagasinage de données est empêché d'être accompli avec succès à moins que le numéro d'identification de contrôleur et le numéro d'identification de dispositif dans la table d'états de la structure en tableau collectif du contrôleur correspondent respectivement aux numéros d'identification de dispositif et de contrôleur sur la piste d'état de dispositif du dispositif d'emmagasinage de données.

4. Procédé selon l'une quelconque des revendications précédentes, dans lequel les dispositifs d'emmagasinage de données répartissent le flot d'informations sur chacune des chaînes, en:

connectant chacun des dispositifs d'emmagasinage de données à la chaîne avec les dispositifs d'emmagasinage au moins attachés;

connectant la pluralité de chaînes à plus d'un moyen des moyens de rattachement du contrôleur de dispositif d'emmagasinage de données.

5. Procédé selon la revendication 2, dans lequel la réponse à des pannes d'un dispositif d'emmagasinage quelconque comprend:

l'augmentation du compte de reconfigurations dans la table d'états de la structure en tableau collectif pour indiquer qu'une reconfiguration a eu lieu; et

l'écriture du compte de reconfigurations augmenté sur la piste d'état de dispositif du dispositif d'emmagasinage de données qui fonctionne.

6. Système de traitement de données pour gérer un premier et un deuxième dispositifs d'emmagasinage (70, 75), comprenant:

un système hôte (110) contenant une pluralité de canaux (120);

un contrôleur (125) rattaché à au moins un des canaux et comprenant un ensemble de trajets de mémoire (140), chacun des trajets de mémoire ayant accès à une antémémoire (145), un contrôleur de dispositif d'emmagasinage de données (160), une mémoire non volatile (220), et une mémoire comprenant une structure en tableau collectif (200) ayant une table de translation de données et une table d'états,

une pluralité de chaînes de dispositifs d'emmagasinage de données (70, 75) attachés au contrôleur de dispositif d'emmagasinage de données (160), chacun des dispositifs d'emmagasinage de données comprenant une pluralité d'enregistrements, une pluralité de pistes, et une piste d'état de dispositif sur laquelle sont enregistrés un compte de reconfigurations, un numéro d'identification de dispositif et un numéro d'identification de contrôleur, la structure en tableau collectif du contrôleur (200) comprenant des moyens pour emmagasiner ledit compte de reconfigurations, ledit numéro d'identification de dispositif et ledit numéro d'identification de contrôleur pour chacun desdits dispositifs d'emmagasinage de données,

des moyens pour attribuer un nombre prédéterminé de bits à chacun des enregistrements emmagasinés dans les premier et deuxième dispositifs d'emmagasinage de données afin d'identifier des changements sur les enregistrements,

des moyens pour emmagasiner sur une pile un numéro de cellule comprenant le nombre prédéterminé de bits pour chacun des enregistrements du premier dispositif d'emmagasinage de données, ledit numéro de cellule étant un champ binaire prédéterminé spécifiant un enregistrement sur lesdits dispositifs d'emmagasinage,

des moyens pour vérifier périodiquement ladite pile afin d'identifier un ensemble d'enregistrements qui ont changé, et

des moyens pour écrire l'ensemble d'enregistrements qui ont changé sur le deuxième dispositif d'emmagasinage de données,

ce qui fait que lesdits premier et deuxième dispositifs d'emmagasinage (70, 75) sont gérés pour maintenir identiques les copies des enregistrements de données qui y sont emmagasinés.

7. Système selon la revendication 6, comprenant en outre un appareil pour assurer l'intégrité desdits dispositifs d'emmagasinage de données (70, 75) après des pannes, ledit appareil comprenant des moyens pour comparer le numéro d'identification de dispositif et le numéro d'identification de contrôleur dans la table d'états dans la structure en tableau collectif avec le numéro d'identification de dispositif et le numéro d'identification de contrôleur sur la piste d'état de dispositif du dispositif d'emmagasinage de données, et des moyens pour invalider l'opération si les numéros d'identification de dispositif et les numéros d'identification de contrôleur ne correspondent pas respectivement.

**FIG. 1**
PRIOR ART

**FIG. 2**

JOINT ARRAY STRUCTURE

| | |
|---|---|
| 300 — DEVICE RELATED OPERATIONAL DATA | |
| 310 — WORK CONTROL ELEMENTS | |
| 320 — LOCK STRUCTURES | |
| 330 — SUBSYSTEM STATUS (IMAGE OF THE GLOBAL STATUS) - DEVICE ADDRESS TRANSLATION | |

340
MIRROR - IMAGE

## FIG. 3

HOST                    HOST

↓ (13) — 400            ↑ (13) — 460
IOS                     IOR

- - - - - - - - - - - - - - - - - - - - - - - - - -

↓

STORAGE SYSTEM — 410

↓                       ↑ (13) — 450

DEVICE ADDRESS TRANSLATION

0 ↓                     0 ↓
  [ 23 ] — (13)         (23) — [ 13 ]
420 —                              — 440
63                      63

↓ (23) — 425

- - - - - - - - - - - - - - - - - - - - - - - - - -

DASD      IOS      IOR →
          ( 23 ) — 430

FIG. 4

FIG. 5